# EUROPÄISCHE PATENTANMELDUNG

(11) **EP 0 802 479 A2**
(43) Veröffentlichungstag der Anmeldung: **22.10.1997**
(21) Anmeldenummer: 96440101.2
(22) Anmeldetag: 28.11.1996
(51) Int. Cl.: G06F 9/445

(54) **Verfahren und Vorrichtung zum Programmieren eines Flash-EEProm**

(30) Priorität: 30.11.1995 DE 19544571
(71) Anmelder: ALCATEL ALSTHOM COMPAGNIE GENERALE D'ELECTRICITE, 75008 Paris (FR)
(72) Erfinder: Kopp, Dieter, 71282 Hemmingen (DE); Sienel, Jürgen, 71229 Leonberg (DE)
(74) Vertreter: Knecht, Ulrich Karl, Dipl.-Ing.

(57) **Zusammenfassung**

Während der Programmierung von Flash-EEProms ist eine intitiierende Prozessoreinheit belegt. Die Zeit der Belegung wird mit steigendem Alter und Benutzungsgrad der Flash-EEProms immer größer.

Verwendung eines über eine Prozessoreinheit initiierbaren Unterbrechungsprogrammes, das eine Programmierung des Flash-EEProms auslöst und welches danach beendet wird, um gleichzeitig mit der Programmierung ein Hauptprogramm weiter zu bearbeiten.

In einer Prozessoreinheit wird eine vorhandene Timerfunktion zum Auslösen eines Unterbrechungsprogrammes verwendet. Das Unterbrechungsprogramm überprüft Ausgangsbedingungen und für den Fall, daß eine Ausgangsbedingung erfüllt ist, wird die Programmierung des Flash-EEProms ausgelöst, woraufhin während der Programmierung wieder mit der Ausführung des Hauptprogrammes in der Prozessoreinheit fortgefahren wird.

## Beschreibung

Häufig verwendete Halbleiterspeicher sind die Flash-EEProms (Flash-Electronically Erasable Programmable read only memory). Diese Speicherbausteine besitzen die Eigenschaft mittels einfacher Steuersignale löschbar und direkt wieder beschreibbar zu sein. Diese Flash-EEProms haben in ihrem Ausgangszustand alle Bits auf einen definierten Zustand, hier z. B. eine Eins gesetzt. Zur Programmierung werden diese Bits von Eins auf Null gesetzt, oder wenn der definierte Zustand eine Null ist, auf eine Eins. Demgemäß findet eine Programmierung derart statt, daß die einzelnen Bits überprüft werden, und zur Programmierung ein Bit von Eins auf Null gesetzt wird. Dieses Setzen erfolgt mittels einer Potentialänderung, die durch eine Programmiersequenz, also eine Folge von Programmierschritten von einer Prozessoreinheit initiiert wird. Eine solche ist direkt oder indirekt mit dem Flash-EEProm verbunden. Innerhalb des Flash-EEProms laufen Algorithmen ab, die die Programmierung überwachen.

Zeitkritisch wird eine solche Programmierung insbesondere dann, wenn das Alter des verwendeten Bausteins und entspechend die Häufigkeit der Benutzung ansteigt. Dies bedeutet, daß das Flash-EEProm n-mal programmiert und danach wieder gelöscht worden ist. Es zeigt sich, daß solche Programmierzeiten bei "älteren" Bausteinen zwischen 8µ und 1ms betragen kann. Wenn, wie vorab erläutert, innerhalb des Flash-EEProms ablaufende Algorithmen eine solche Programmierung überwachen, kann während dieser Programmierzeit und der Verwendung von sogenannnten 'data polling algorithms' von der Prozessoreinheit keine weitere Aufgabe ausgeführt werden.

Solche 'data polling algorithms' in Verbindung mit den entsprechenden Speicherbausteinen sind aus folgenden Veröffentlichungen bekannt: AMD flash memory products, Data Book/Handbook 1994/95. Hierin wird beschrieben, daß dieses 'data polling' eine Methode ist, um der Prozessoreinheit, die im folgenden kurz CPU genannt werden soll, anzuzeigen, ob eine Programmierung noch in Arbeit ist, oder ob sie bereits beendet ist. Bei Verwendung dieser 'data polling algorithms' kann aber von der CPU kein weiteres Programm, wie z. B. das Hauptprogramm ausgeführt werden.

In einem weiteren Stand der Technik der Firma Intel werden sogenannte 'byte write flash block erase polling Algorithmen' beschrieben. Dieser legt eine Hardwaremethode dar, um festzustellen, ob das Schreiben eines Bytes oder das Löschen eines Blocks beendet wurde. Auch hierbei kann während dieser Schreibprozedur die CPU keine weiteren Programme ausführen (aus: intel Flash Memory, Volume 1, Jahrgang 1994).

Bei den beiden voran vorgestellten Algorithmen ist, wie bereits erläutert die CPU während des Schreibens belegt. Da sich bei dem Programmieren eines Flash-EEProm mit steigendem Alter des Bausteines größere Zeiten ergeben, die verwendet werden um einen solchen Speicher zu programmieren, kann dies zu sehr langen Belegungszeiten der CPU führen, in denen diese dann nicht zur Ausführung von Programmen zur Verfügung steht.

Demgemäß ist es Aufgabe der vorliegenden Erfindung ein Verfahren und eine Vorrichtung zu entwickeln, bei der während des Programmierens eines Flash-EEProms die CPU nicht belegt ist. Dies wird erfindungsgemäß gelöst durch die Lehre des Anspruchs 1 und durch die Lehre des Anspruchs 4.

Ein besonderer Vorteil hierbei ist es, daß zum Beispiel bei zeitkritischen Anwendungen, wie zum Beispiel bei einem digitalen Anrufbeantworter oder bei einer Sprachmailbox, kein Verlust der Echtzeitaufnahme von Anrufen zutage tritt. Denn bei längeren Programmierzeiten die bis zu 1ms betragen können, würde dies zum Verlust der Echtzeitaufnahme von Anrufen führen, was die benutzerfreundlichkeit stark einschränken würde.

Weitere vorteilhafte Ausgestaltungen lassen sich den Unteransprüchen 2 bis 3, und den Unteransprüchen 5 bis 6 entnehmen.

Im Folgenden wird die Erfindung anhand von Figuren näher erläutert.
- Fig. 1:: Ablaufdiagramm eines erfindungsgemäßen Verfahrens,
- Fig. 2:: Blockschaltbild einer erfindungsgemäßen Vorrichtung zur Ausführung des Verfahrens.

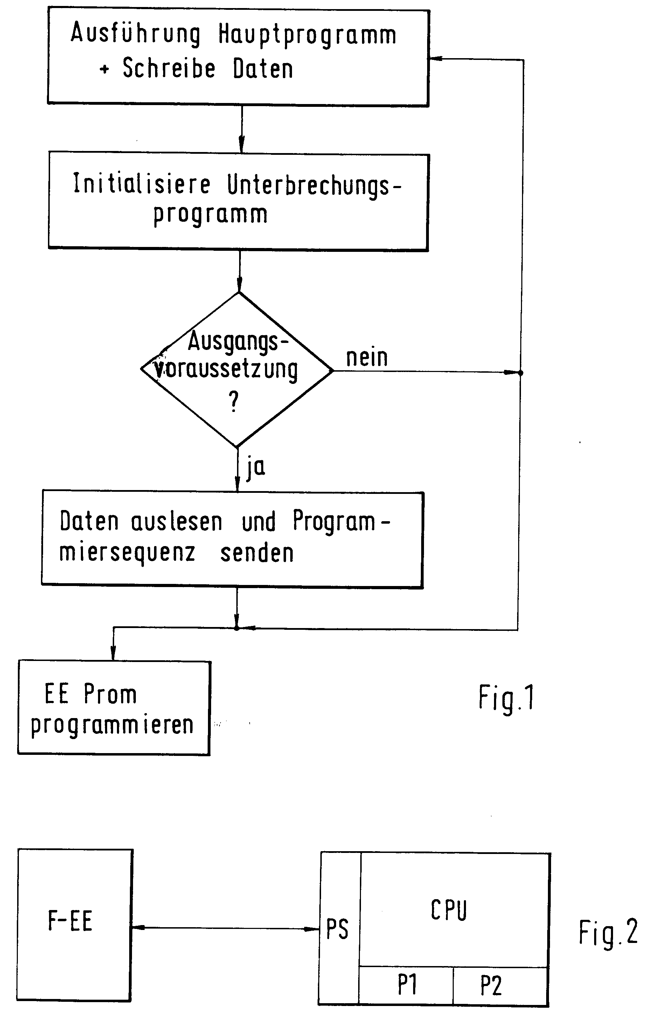

Im folgenden wird das Verfahren anhand der Figur 1 eingehend erläutert.

Das Verfahren zum Programmieren eines Flash-EEProms weist folgende Schritte auf. In einer Prozessoreinheit läuft ein Hauptprogramm zur Bearbeitung von Daten ab. Dieses Hauptprogramm veranlaßt, daß bearbeitete Daten in einen Pufferspeicher geschrieben werden. Dieser Pufferspeicher kann beispielsweise in einer besonderen Auführungsform ein Ringpuffer sein. Wird eine herkömmliche Prozessoreinheit wie zum Beispiel ein Microcontroller oder ein digitaler Signalprozessor (DSP) verwendet, besitzt diese Prozessoreinheit im allgemeinen eine Timerfunktion. Unter Verwendung dieser Timerfunktion wird in regelmäßigen Zeitabständen das gerade ablaufende Hauptprogramm unterbrochen. Weiter wird damit ein Unterbrechungsprogramm (interrupt routine) initialisiert. Das Unterbrechungsprogramm überprüft eine Ausgangsbedingung. Für den Fall, daß diese Ausgangsbedingung nicht erfüllt ist, wird mit der Ausführung des Hauptprogramms fortgefahren. Für den Fall aber, daß diese Ausgangsbedingung erfüllt ist, werden die Daten aus dem Pufferspeicher ausgelesen und eine Programmiersequenz wird an den zu programmierenden Flash-EEProm gesendet. Dies geschieht genau für den Fall, daß in dem Pufferspeicher noch zu schreibende Daten vorhanden sind. Nach dem Senden der Programmiersequenz an den Flash-EEProm wird das Hauptprogramm weiter ausgeführt. Gleichzeitig damit wird die Programmierung des Flash-EEProms durchgeführt. Daraus ergibt sich, daß eine Ausgangsbedingung ist, ob die letzte Programmierung erfolgreich abgeschlossen worden ist. Denn wenn der Flash-EEProm immer noch im Schreibzustand ist, soll keine neue Programmiersequenz mit neuen zu schreibenden Daten an den Flash-EEProm gesendet werden, vielmehr muß ein zuvor initiierter Schreibvorgang erst erfolgreich beendet werden.

Weiterhin wird überprüft, ob nach vollzogenem Schreiben das Schreiben erfolgreich, also vollständig und fehlerlos beendet worden ist.

Eine weitere vorteilhafte Ausgestaltung ist es, den Zeitabstand zwischen der Inititalisierung von Unterbrechungsprogrammen größer als eine durchschnittliche Programmierzeit des Flash-EEProm zu wählen. Damit kann ein Zeitgewinn erreicht werden. Denn es ist dann davon auszugehen, daß bei jedem Unterbrechungsprogramm vorher ein erfolgreich abgeschlossener Programmiervorgang im Flash-EEProm abgelaufen ist, wobei ja wie bereits zuvor erwähnt, gleichzeitig das Hauptprogramm weiter abgelaufen ist.

Im folgenden wird anhand von Figur 2 eine Vorrichtung zur Programmierung eines Flash-EEProms näher erläutert.

Die Vorrichtung zur Programmierung eines Flash-EEProms besteht aus einer Prozessoreinheit CPU, die ein Hauptprogramm P1 ausführt, und von der aus ein Unterbrechungsprogramm P2 initialisiert wird. Das Hauptprogramm P1 in der Prozessoreinheit CPU schreibt bearbeitete Daten in einen Pufferspeicher PS. Dieser Pufferspeicher ist in einer vorteilhaften Ausführung ein Ringpuffer. Das Unterbrechungsprogramm P2 liest Daten aus dem Pufferspeicher PS aus und ein Flash-EEProm F-EE, welches programmiert werden soll, wird programmiert indem das Unterbrechungsprogramm P2 Daten aus dem Pufferspeicher PS ausliest und eine Programmiersequenz sendet. Unter einer Programmiersequenz ist eine Folge von Programmierschritten zu verstehen.

Eine besonders vorteilhafte Verwendung einer Vorrichtung nach Anspruch 4 ist beispielsweise in einem digitalen Anrufbeantworter zu sehen. Bei digitalen Anrufbeantwortern fallen zu programmierende Daten kontinuierlich an, wie z. B. bei einer Sprachkompression zur Sprachaufzeichnung. Unter diesen gegebenen Voraussetzungen können Zeit und Größe des Pufferspeichers derart gewählt werden, daß eine kontinuierliche Verteilung des Schreibvorgangs über eine gesamte Zeit und somit unabhängig von der tatsächlichen Programmierzeit gewählt werden kann. Da bei einer Sprachkomprimierung und den dazu verwendeten Sprachkomprimierungsalgorithmen im allgemeinen ein reziprokes Verhältnis der Rechenleistung zur Datenrate existiert, ergibt sich bei allen Komprimierungsarten mittels Komprimierungsalgorithmen eine optimale Ausnützung der zur Verfügung stehenden Rechenleistung der zentralen Prozessoreinheit.

## Patentansprüche

1. Verfahren zum Programmieren eines Flash-EEProms,
bei dem ein Hauptprogramm zur Bearbeitung von Daten in einer Prozessoreinheit ausgeführt wird
und bei dem das Hauptprogramm die bearbeiteten Daten in einen Pufferspeicher schreibt
und bei dem in regelmäßigen Zeitabständen von der Prozessoreinheit ein Unterbrechungsprogramm initialisiert wird,
bei dem das Unterbrechungsprogramm eine Ausgangsbedingung überprüft und dann, wenn die Ausgangsbedingungen erfüllt ist, die Daten aus dem Pufferspeicher ausliest und eine Programmiersequenz an den zu programmierenden Flash-EEProm sendet,
und bei dem nach dem Senden der Programmiersequenz das Hauptprogramm weiter ausgeführt wird, während die Programmierung des Flash-EEProms ausgeführt wird.

2. Verfahren nach Anspruch 1,
bei dem das Unterbrechungsprogramm als Ausgangsbedingung überprüft, ob ein Flash-EEprom nicht mehr im Schreibzustand ist oder ob zu programmierende Daten im Pufferspeicher sind, und dann eine Programmiersequenz an den Flash-Speicher sendet.

3. Verfahren nach Anspruch 1 oder 2, bei dem der Zeitabstand zwischen der Initialisierung von Unterbrechungsprogrammen größer als eine durchschnittliche Programmierzeit des Flash-EEproms gewählt wird.

4. Vorrichtung zur Programmierung eines Flash-EEproms (F-EE), mit einer Prozessoreinheit (CPU), die ein Hauptprogramm (P1) ausführt und ein Unterbrechungsprogramm (P2) initialisiert, mit einem Pufferspeicher (PS), in den von dem Hauptprogramm bearbeitete Daten geschrieben werden, und mit dem Flash-EEprom (F-EE), welcher programmiert wird, indem das Unterbrechungsprogramm (P2) eine Ausgangsbedingung überprüft, Daten aus dem Pufferspeicher ausliest und eine Programmiersequenz an den zu programmierenden Flash-EEprom (F-EE) sendet.

5. Vorrichtung nach Anspruch 4, bei dem der Pufferspeicher ein Ringpuffer ist.

6. Verwendung einer Vorrichtung nach Anspruch 4 in einem digitalen Anrufbeantworter.
